# EUROPEAN PATENT APPLICATION

(11) **EP 4 407 329 A1**
(43) Date of publication of application: **31.07.2024**
(21) Application number: 23153045.2
(22) Date of filing: 24.01.2023
(51) Int. Cl.: G01R 31/367, G01R 31/3842, H02J 7/00

(54) **METHOD AND DEVICE FOR DETERMINING A DERATED POWER LIMIT OF A BATTERY**

(71) Applicant: Rimac Technology LLC, 10431 Sveta Nedelja (HR)
(72) Inventor: DINNEPATI, Siddarth, 10000 Zagreb (HR)
(74) Representative: Hoffmann Eitle

(57) **Abstract**

A method for determining a derated power limit of a battery, the method comprising: estimating a power limit of the battery; acquiring a plurality of inputs from the battery; determining a derating factor for the power limit by applying a fuzzy logic to the plurality of inputs; and determining the derated power limit by multiplying the derating factor to the power limit.

## Description

### Technical field

The present invention generally relates to a method for determining a power limit of a battery and more particularly, to a method for determining a derated power limit of the battery based on a fuzzy logic.

### Technical background

An essential aspect of a battery management system (BMS) is to keep the battery within safe operating conditions and to avoid the battery entering unsafe operating conditions. One such unsafe operating condition is undervoltage, i.e., operating the battery with a voltage below a lower safety limit. This may occur when the limits, in particular the power limits, are overestimated: In such a case, the voltage may drop below a lower safety limit which in turn triggers the BMS to derate the power. As a result, the performance of the system driven by the battery, e.g., a vehicle, is negatively impacted and the safety of the battery and its environment is at risk.

Accordingly, a precise estimation of the maximum power is paramount to prevent unsafe operating conditions such as undervoltage.

Generally, however, the state of a battery including quantities such as state of charge (SoC), state of power (SoP) and state of health (SoH), is not directly observable and thus can only be inferred indirectly from observable quantities such as current, voltage and temperature of the battery.

The estimation of the state of power is of particular interest for the determination of the maximum charge/discharge power as the two concepts have a clear relation to each other: power limits are determined by considering how much power a battery can provide maximally for a predetermined amount of time. However, conventionally, estimation of the state of power may suffer from a plurality of uncertainties which in turn lead to an overestimation of the power limit. Among them are the inaccuracy of the estimation algorithm itself and an inaccurate cell model for estimating the state of charge underlying the state of power estimation.

One possible approach to address this could be an improved model leading to a more precise state of charge estimation, which in turn could also improve the state of power estimation. This task has been proven to be rather difficult, in particular in those ranges of battery operation parameters in which conventional models fail.

An alternative possibility would be to increase the complexity of the algorithm, i.e., to take more parameters and interactions between parameters into account. As this approach increases the computational requirements, this may be impractical, in particular when the algorithm should work on an embedded system with limited resources, as for example, within an electric vehicle.

Thus, there is a need for an improved power limit estimation that allows for a more accurate estimation of the power limits of a battery without increasing the computational requirements.

### Summary

The above problems are solved by the subject-matter of independent claims. Preferred embodiments are given by the subject-matter of dependent claims. Further examples are provided for facilitating the understanding of the invention.

According to an embodiment of the present invention, there is provided a method for determining a derated power limit of a battery, the method comprising: estimating a power limit of the battery; acquiring a plurality of inputs from the battery; determining a derating factor for the power limit by applying a fuzzy logic to the plurality of inputs; and determining the derated power limit by multiplying the derating factor to the power limit.

According to an embodiment of the present invention, there is provided a device for determining a derated power limit of a battery, the device configured to: estimate a power limit of the battery; acquire a plurality of inputs from the battery; determine a derating factor for the power limit by applying a fuzzy logic to the plurality of inputs; and determine the derated power limit by multiplying the derating factor to the power limit.

According to an embodiment of the present invention, there is provided a vehicle comprising the device described above.

The present invention can provide a method for determining a derated power limit of a battery which can prevent overestimation of a power limit of the battery and thereby preventing sudden voltage drops triggered by crossing the power limit of the battery.

### Brief description of the drawings

Embodiments of the present invention, which are presented for better understanding the inventive concepts, but which are not to be seen as limiting the invention, will now be described with reference to the figures in which:
- Figure 1: shows a flowchart of a method according to an embodiment of the present invention;
- Figure 2: shows membership functions for the plurality of inputs according to an embodiment of the present invention;
- Figure 3: shows a membership function for the output according to an embodiment of the present invention;
- Figure 4: shows a device embodiment of the present invention;
- Figure 5: shows a graph of battery power and a graph of battery voltage of an exemplary method; and
- Figure 6: shows a graph of battery power and a graph of battery voltage according to an embodiment the present invention.

### Detailed description

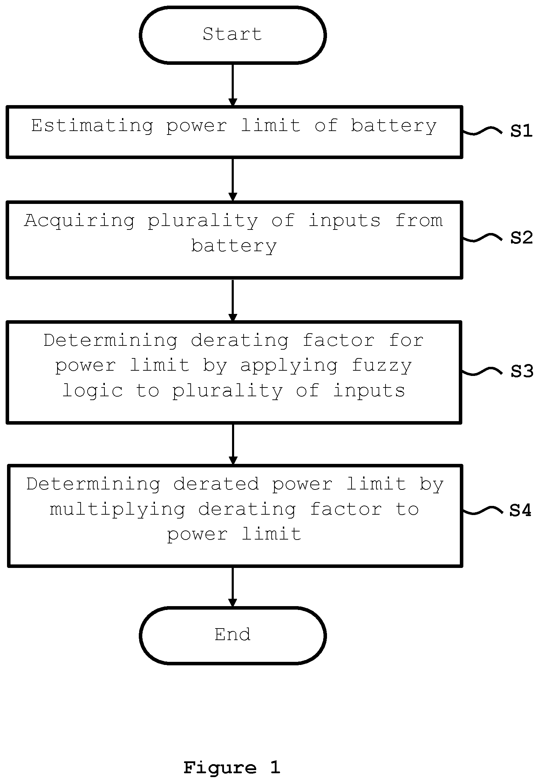

Figure 1 shows a flowchart of a method according to an embodiment of the present invention. The method for determining a derated power limit of a battery comprises: estimating (step S1) a power limit of the battery; acquiring (step S2) a plurality of inputs from the battery; determining (step S3) a derating factor for the power limit by applying a fuzzy logic to the plurality of inputs; and determining (step S4) the derated power limit by multiplying the derating factor to the power limit.

In the first step S1 of estimating a power limit of the battery, the power limit of the battery is estimated. The power limit may refer to a limit of the power that is discharged from the battery in case of discharging of the battery or to a limit of the power that is charged to the battery in case of charging of the battery.

The power limit of the battery can be estimated using different methods based on different variables which will be discussed in a different part of this document. In particular, step S1 of estimating a power limit is not limited and can refer to any method or algorithm used for estimating the power of a battery.

In the second step S2, the plurality of inputs is acquired from the battery. The plurality of inputs may be a plurality of variables that can be drawn from the battery which can represent a state of the battery or which are related to the battery and/or available information related to the battery or the estimation of the state of the battery. The plurality of inputs may be acquired directly or indirectly from the battery. That is, the plurality of inputs may refer to quantities that can be directly measured from the battery or quantities that be derived indirectly from other quantities. Also, the plurality of inputs may refer to inputs to be input to the fuzzy logic. Further details of the plurality of inputs will be discussed at a different part of this document.

In the third step S3, a derating factor for the power limit is determined by applying a fuzzy logic to the plurality of inputs. The fuzzy logic taking the plurality of inputs as its input may output the derating factor as a result of the fuzzy logic. Further details of the fuzzy logic will be discussed in a different part of this document.

Throughout the present application, fuzzy logic refers to a many-valued logic in which values of variables take more general forms than in Boolean logic. Boolean logic allows variables to take values of either 'true' (or `1') or 'false' (or `0'). Different from that, fuzzy logic is a many-valued logic in which the full interval between 0 and 1 can be used, i.e., partial truths can be used. As an example, if a Boolean logic system would allow a state to be either "cold" or "hot" (representing the two opposites of 0 and 1), a fuzzy logic system would allow more than two states, for example "cold", "neutral" and "hot", but also intermediate states thereof that would correspond to 'somewhere between "cold" and "neutral"', or, in more mathematical terms, could be expressed as '0.5 · "cold" + 0.5 · "neutral"'. Fuzzy logic may be advantageous if a scenario cannot be divided into "false" and "truth" such as done in Boolean logic, but instead an assessment in nuances, that is, partial truths, is required.

For the situation at hand this may be understood as follows: Depending on the circumstances, one might be aware that the pre-existing algorithm for estimating the power limit of a battery performs poorly in a certain parameter range. A Boolean logic approach would only allow to either rely on the algorithm's estimation nevertheless (which would then correspond to a Boolean value of 1 or true) or discard the algorithm's estimation (which would then correspond to a Boolean value of 0 or false). In both cases, one is provided with a suboptimal result as either one uses a power limit estimation of which one is aware that it is not providing an accurate (enough) result or one discards the inaccurate estimation and has no estimation of the power limit at all.

A solution to this may be provided by fuzzy logic: Here, the information that the system is in a parameter range in which the algorithm performs less than optimally, for example, overestimates the power limit, can be used to assign a fuzzy logic value to this scenario which then can influence the assessment of the estimation provided gradually and, for example, be used to correct the estimation of the power limit.

Given the gradual character that fuzzy logic introduces, parameters which have a certain, preferably well-defined range and have a well understood impact on the system may be particularly good candidates to be used when applying fuzzy logic to a system.

In the fourth step S4, the derated power limit of the battery is determined by multiplying the derating factor to the estimated power limit. That is, the estimated power limit and the derating factor determined by using fuzzy logic are used together to correct, i.e., derate, the estimated power limit based on the results of the fuzzy logic determination. In other words, the plurality of inputs can be understood as indicators of the quality of the estimation of the power limit and the fuzzy logic is able to use these indicators, the plurality of inputs, to determine a correction factor, the derating factor, that is then applied to the estimated power limit, leading to a derated power limit replacing the estimated power limit with a more accurate power limit. In this context, 'derating' may be understood as `correcting', and/or 'reducing'.

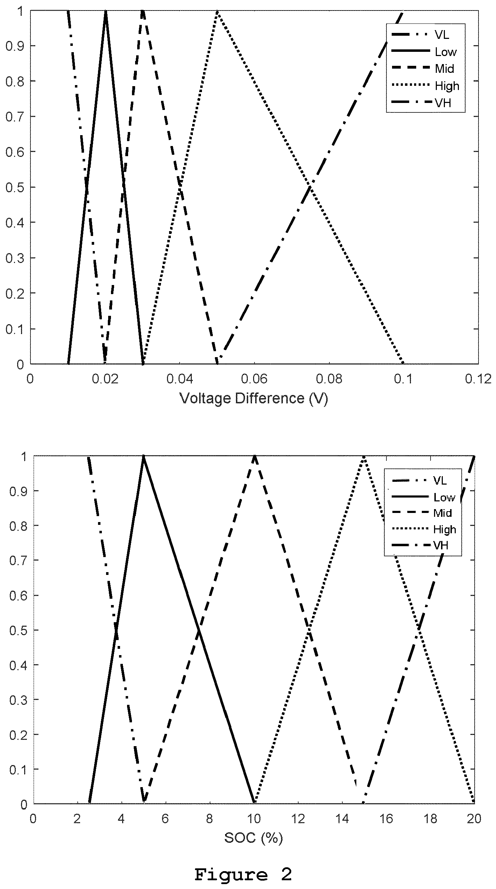

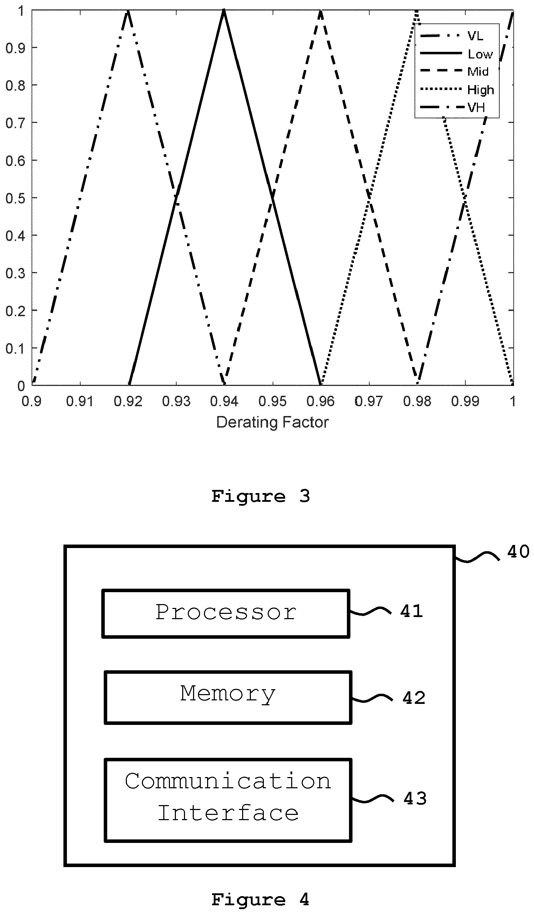

Further, as fuzzy logic can be a very computationally simple approach that neither requires particular computational power nor storage capacities, this improvement of the estimation of the power limit is particularly advantageous when also considering the computational costs of an estimation algorithm are desired to be limited and/or when computational resources are limited. Details of the fuzzy logic will be discussed further below in more detail, in particular in combination with Figures 2 and 3.

Moreover, the method may comprise estimating a voltage of the battery and a state of charge of the battery based on an equivalent circuit model. As a battery being charged or being discharged is an electric circuit, this can be modelled by an equivalent circuit model and accordingly the voltage of the battery as well as the state of charge of the battery can be estimated based on said equivalent circuit model. Parameters of the equivalent circuit model may be defined in advance.

The state of charge can be determined in various ways. One way is using 'Coulomb counting', i.e., measuring the discharge/charge (the current flowing out of/into the battery) at each time step and integrating over this discharge/charge. While this method is generally applicable, it relies on the accuracy of the discharge/charge measurement and is prone to errors due to noise of the discharge/charge measurement.

In this case, the method may further comprise measuring a voltage of the battery, a current of the battery and a temperature of the battery, wherein the state of charge is estimated based on at least the measured voltage, the measured current and the measured temperature.

Further, the state of charge may be corrected based on a voltage difference between the measured voltage and the estimated voltage. The voltage difference may be calculated by a subtraction of the estimated voltage from the measured voltage. This correction of the state of charge may be implemented using a Kalman filter.

One possibility for estimating the power limit of the battery may be based on at least an estimated voltage of the battery and the state of charge of the battery.

Further, the plurality of inputs may include at least one of the state of charge, a voltage difference between the measured voltage and the estimated voltage, the measured temperature and a state of health of the battery. Preferably, the plurality of inputs includes at least the state of charge and the voltage difference. Moreover, any other parameter that may have an impact on how much power can be drawn from/supplied to the battery may be included in the plurality of inputs.

In the following, further details regarding the fuzzy logic will be described.

Applying the fuzzy logic to the plurality of inputs may comprise converting each of the plurality of inputs into each of a plurality of fuzzy inputs. This can be understood as using predefined membership functions to convert the inputs into fuzzy inputs, for example converting a value of a parameter related to the battery and/or its state into a fuzzy input indicating partial truths corresponding thereto. Applying the fuzzy logic to the plurality of inputs may comprise mapping the plurality of fuzzy inputs to a fuzzy output and converting the fuzzy output to an output of the fuzzy logic, wherein the output is the derating factor. Each of the plurality of inputs may be converted (also: fuzzified) into the each of the plurality of fuzzy inputs by corresponding input membership functions; and the fuzzy output may be converted (also: defuzzied) into the output of the fuzzy logic by an output membership function. Along with this output membership function, a weighted average method may be used to get the output of the fuzzy logic.

This can be understood as converting the fuzzy output to a (single) output, for example, for the case at hand, converting the fuzzy inputs into a fuzzy output and then the fuzzy output into an output that indicates how the power limit estimation has to be corrected in view of the inputs and the evaluation thereof by the fuzzy logic.

Further, the plurality of fuzzy inputs may be mapped into the fuzzy output by a fuzzy inference, wherein the fuzzy inference maps the fuzzy inputs into the fuzzy output by modelling relationships between the fuzzy inputs and the fuzzy output. This may also be understood as using statistical relationships between the fuzzy inputs and the fuzzy output.

Figure 2 shows membership functions for the plurality of inputs according to an embodiment of the present invention, while Figure 3 shows a membership function for the output according to an embodiment of the present invention. Specifically, Figure 2 relates to the case that the voltage difference between a measured and an estimated voltage of the battery (see top plot) and the state of charge of the battery (see bottom plot) are used as inputs. The top plot shows the input membership functions converting a voltage difference in the range from 0 to 0.12 V to a fuzzy input. The fuzzy inputs can be represented with partial truths of: Very Low (VL), Low, Medium, High and Very High (VH). According to this specific example, a voltage difference in the range from 0 to 0.01 V is converted in "Very Low", a voltage difference in the range from 0.01 to 0.02 V is converted into a combination of "Very Low" and "Low", a voltage difference in the range from 0.02 to 0.03 V is converted into a combination of "Low" and "Medium", a voltage difference in the range from 0.03 to 0.05 V is converted into a combination of "Medium" and "High", a voltage difference in the range from 0.05 to 0.1 V is converted into a combination of "High" and "Very High", and a voltage difference beyond 0.1 V, that is, in the range between 0.1 and 0.12 V, is converted into "Very High". Further, as it can be seen from the plot, the combination of two partial truths of a fuzzy input is a linear function in the voltage difference and the sum of the coefficients of the coefficients corresponding to any specific voltage difference value adds up to 1. While the latter condition may be reasonable in some applications, it is stressed that the shape of the functions/combinations is not particularly limited and may take any form. In other words, the membership function can be interpreted as assigning to each voltage difference value a quantitative assessment how big this voltage difference is, and allowing the assessment to be more gradual than possible within a Boolean logic system that would only allow "Very Low", "Low", "Medium", "High" and "Very High", but not "0.5 · Very Low + 0.5 · Low" such as associated with a voltage difference of 0.025 V according to the plot.

In a similar manner, the lower plot indicates how a state of charge in the range of 0 to 20 % is converted into a fuzzy input, once again categorized into the fuzzy inputs having partial truths of: Very Low (VL), Low, Medium, High and Very High (VH). According to this specific example, a state of charge in the range from 0 to 2.25 % is converted in "Very Low", a state of charge in the range from 2.25 to 5 % is converted in a combination of "Very Low" and "Low", a state of charge in the range from 5 to 10 % is converted in a combination of "Low" and "Medium", a state of charge in the range from 10 to 15 % is converted in a combination of "Medium" and "High", a state of charge in the range from 15 to 20 % is converted in a combination of "High" and "Very High". Further, as discussed above, it can be seen from the plot that the combination of two partial truths of a fuzzy input is a linear function in state of charge and the sum of the coefficients of the coefficients corresponding to any specific state of charge value adds up to 1. While the latter condition may be reasonable in some applications, it is stressed that the shape of the functions/combinations is not particularly limited and may take any form. The membership function can be interpreted as assigning to each state of charge value a quantitative assessment how big this state of charge is, and allowing the assessment to be more gradual than possible within a Boolean logic system that would only allow "Very Low", "Low", "Medium", "High" and "Very High", but not "0.5 · Very Low + 0.5 · Low" such as associated with a state of charge of 4 % according to the plot.

Figure 3 shows a corresponding plot in which fuzzy output, once again having partial truths of Very Low (VL), Low, Medium, High and Very High (VH), and which can be mapped into an output, that is, into a derating factor. As this plot is conceptually the same, but to be used inversely since it does not convert an input into a fuzzy input, but a fuzzy output into an output, the discussion of this plot will be abridged, and reference is made to the above discussion of Figure 2 as its discussion substantially applies here as well.

To further illustrate the functioning of the fuzzy logic, in the following details of the fuzzy inference (system), i.e., the mapping from fuzzy inputs into fuzzy output will be discussed. As discussed above, the fuzzy inference has the purpose of modelling the relationship between fuzzy inputs and fuzzy output. In the specific example shown in Figures 2 and 3, that means to infer from the voltage difference and the state of charge a derating factor.

In more illustrative terms, this can be understood as trying to infer from the knowledge that the voltage estimation is imperfect, i.e., a non-zero voltage difference, and that the power limit estimation algorithm overestimates the power limit, i.e., the state of charge is low, a known scenario in which the cell model and thus the power limit estimation performs poorly, how much the estimated power limit has to be adjusted, i.e., derated, to correct for these deficiencies.

One way to implement this inference system is to use IF-THEN statements that connect two fuzzy inputs with one fuzzy output such as:
*IF* SoC is Low and voltage difference is Very High, *THEN* set Derating to Very High.
*IF* SoC is Low and voltage difference is Very Low, *THEN* set Derating to Medium.
*IF* SoC is Very Low and voltage difference is Low, *THEN* set Derating to Very High.

If one has a full set of such IF-THEN statements, i.e., one for each possible combination of the fuzzy inputs, every fuzzy input can be mapped into a fuzzy output. Also, the fuzzy inference may assign a value to each partial truth based on fuzzy inference rules such as the IF-THEN statements. Moreover, these statements can also be used when one fuzzy input is a combination of two fuzzy input values. For example, if one fuzzy input is "Low" and the second fuzzy input is "0.3 · Medium + 0.7 · High", then the pairs "Low"/"Medium" and "Low"/"High" are provided separately as inputs to the inference system, resulting in separate fuzzy outputs and the combination is obtained by weighting each fuzzy output with the corresponding weight, e.g., 0.3 or 0.7. This works analogously in case both fuzzy inputs are combinations. The resulting fuzzy output is then used as an input for the fuzzy output membership function and an output is obtained. In terms of Figure 3, that means that an output, such as "0.5 · Very Low + 0.5 · Low", is converted into a derating factor, in this case 0.93, and this derating factor can be used to adjust the estimated power limit to arrive at a more accurate estimation of the power limit of the battery. Since a weighted average method can be used to acquire the fuzzy output, it is also possible to acquire the output of the fuzzy logic when the fuzzy output has more than two partial truths as explained above. In this case, the output of the fuzzy logic may be the centroid of the fuzzy output.

The specific parameters of the membership functions as well as the inference system may be tuned as appropriate for the particular application of the battery.

In a further example in which at least one of the state of charge and the voltage difference are included in the plurality of inputs, the state of charge and the derating factor are positively correlated; and/or the voltage difference between the measured voltage and the estimated voltage and the derating factor are negatively correlated.

In this case, the input membership functions, the output membership function and the fuzzy inference may be such that the fuzzy logic achieves the following relations: the state of charge and the derating factor are positively correlated; and/or the voltage difference between the measured voltage and the estimated voltage and the derating factor are negatively correlated.

This can be understood as follows: If the state of charge is low, the derating factor would be also low to derate the power limit of the battery. Since the derating factor is multiplied with the power limit of the battery, the smaller the derating factor is, the more power limit is derated, that is, the amount of correction to avoid overestimation of the battery is larger. Similarly, if the voltage difference is large, the derating factor would be low, which means, if value of the estimated voltage deviates a lot from an actual voltage value of the battery, that is, the measured voltage, the derating factor would be smaller to derate the power limit of the battery more.

In a similar fashion, these correlations can be understood as indicating how the derating factor behaves as a function of the state of charge or the voltage difference, assuming that the other input is kept constant. More specifically, the state of charge and the derating factor being positively correlated means that if the state of charge increases (while the voltage difference stays constant), the derating factor increases (and vice versa). Accordingly, the voltage difference between the measured voltage and the estimated voltage and the derating factor being negatively correlated means that if the voltage difference increases (while the state of charge stays constant), the derating factor decreases (and vice versa).

Clearly, depending on the tuning of the fuzzy logic, one of these correlations may be stronger than the other. That is, if both the voltage difference and the state of charge increase, it depends on the tuning of the fuzzy logic, i.e., on the input and output membership functions as well as the fuzzy inference, whether the derating factor increases or decreases, i.e., whether the positive or the negative correlation prevails overall.

In a further example, the derated power limit may be a maximum discharge power of a battery when the battery is discharging; or the derated power limit may be a maximum charge power of a battery when the battery is charging.

Figure 4 shows a device embodiment of the present invention, specifically a device 40 comprising a processor 41, a memory 42 and a communication interface 42. The device 40 and/or the elements making up the device 40 may be configured to perform a method for determining a derated power limit of a battery. That is, the device 40 may be understand as a device for determining a derated power limit of a battery, the device being configured to: estimate a power limit of the battery; acquire a plurality of inputs from the battery; determine a derating factor for the power limit by applying a fuzzy logic to the plurality of inputs; and determine the derated power limit by multiplying the derating factor to the power limit.

Such a device may find application in a vehicle, in particular in an electric vehicle. In other words, a vehicle, preferably an electric vehicle may comprise a device 40 as discussed above in order to provide the electric vehicle during operation with an improved algorithm for determining a power limit.

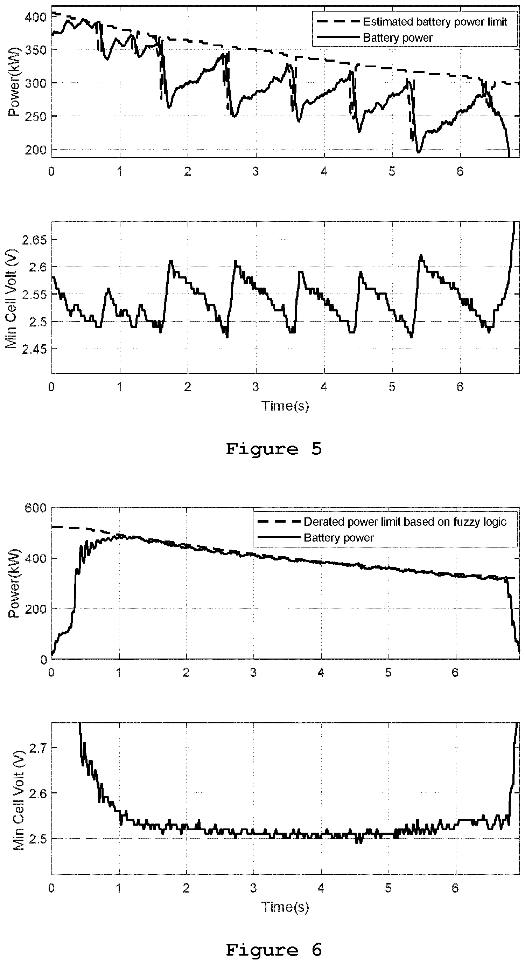

In the following, in particular in connection with Figures 5 and 6, possible advantages of a method according to an embodiment of the present invention will be discussed. Figure 5 shows a graph of battery power and a graph of battery voltage of an exemplary method and Figure 6 shows a graph of battery power and a graph of battery voltage according to an embodiment of the present invention. Both figures have two plots and these plots of Figure 5 and Figure 6 show the same quantities: The top plots show the power of the battery as function of time, in particular the estimated power (in a dashed line) and the actual battery power (in a solid line). The lower plots show the battery voltage at corresponding times.

The main difference between Figure 5 and Figure 6 is that while Figure 5 relates to a scenario in which a conventional algorithm to estimate the power limit is used, Figure 6 shows data in a scenario in which the power limit is estimated using a method according to an embodiment of the present invention, that is, the estimated power limit is subject to derating based on the fuzzy logic as discussed above.

Specifically, Figure 6 shows an example in which the plurality of inputs used for the fuzzy logic include the voltage difference between measured and estimated voltage and the state of charge. These inputs may be chosen, for example, if the cell model used for estimating the state of charge and in thus in turn also the power limit performs less good for low state of charge values and as an indicator for the level of performance of the cell model: As the voltage difference is the difference between the measured and the estimated voltage (which is estimated using the cell model), it can serve as an indicator of the performance of the cell model.

As can be seen in Figure 5, the battery power (top plot) regularly drops steeply and the voltage of the battery drops below the minimum battery voltage which is set to be 2.5 V in this example. As explained elsewhere in this document, this is due to the conventional power limit estimation algorithm overestimating the power limit of the battery. If then the battery is operated beyond the actual power limit (but below the overestimated power limit), the voltage may drop below the minimum voltage value of 2.5 V which triggers a derating in the system, leading to a significant reduction in the battery power being provided as well as the reduced estimated battery power seen in the top plot of Figure 5. Aside from the safety dangers that clearly accompany the voltage dropping below the lower safety value of 2.5 V, the drop in the actual power provided by the battery as a safety measure in response to the dropping voltage may affect the application for which the battery is used negatively as well as the drops in the battery power are also experienced in the application using the battery. For example, if the battery is used in an electric vehicle, these drops in battery power may lead to a "stuttering" effect during accelerating the vehicle.

On the other hand, the estimation of the power limit employing fuzzy logic and derating the estimated power limit based thereon according to an embodiment of the present invention as shown in Figure 6 can eliminate or reduce these phenomena. As it can be seen in the lower plot of Figure 6, which shows substantially the same application of the battery as shown in Figure 5, the cell voltage does not drop below the minimum value of 2.5 V and the power drawn from the battery does not show any drops but instead approaches smoothly the estimated power limit. Accordingly, as the power limit is estimated accurately and the voltage does not drop below the safety value of 2.5 V, there is no need for (rapid) derating of the battery power as shown in Figure 5 as no safety hazard exists. Accordingly, also the application of the battery does not suffer from any drops in battery power and associated "stuttering"-like effects.

Although detailed embodiments have been described, these only serve to provide a better understanding of the invention defined by the independent claims and are not to be seen as limiting to the present invention.

## Claims

1. A method for determining a derated power limit of a battery, the method comprising:
estimating a power limit of the battery;
acquiring a plurality of inputs from the battery;
determining a derating factor for the power limit by applying a fuzzy logic to the plurality of inputs; and
determining the derated power limit by multiplying the derating factor to the power limit.

2. The method according to claim 1, wherein the method further comprises:
estimating a voltage of the battery and a state of charge of the battery based on an equivalent circuit model.

3. The method according to claim 2, wherein the method further comprises:
measuring a voltage of the battery, a current of the battery and a temperature of the battery,
wherein the state of charge is estimated based on at least the measured voltage, the measured current and the measured temperature.

4. The method according to claim 3, wherein
the state of charge is corrected based on a voltage difference between the measured voltage and the estimated voltage.

5. The method according to any one of claims 1 to 4, wherein estimating the power limit of the battery is based on at least the estimated voltage and the state of charge.

6. The method according to any one of claims 3 to 5, wherein
the plurality of inputs includes at least one of the state of charge and a voltage difference between the measured voltage and the estimated voltage, the measured temperature and a state of health of the battery.

7. The method according to any one of claims 1 to 6, wherein applying the fuzzy logic to the plurality of inputs comprises:
converting each of the plurality of inputs into each of a plurality of fuzzy inputs;
mapping the plurality of fuzzy inputs to a fuzzy output; and
converting the fuzzy output to an output of the fuzzy logic, wherein
the output is the derating factor.

8. The method according to claim 7, wherein
the each of the plurality of inputs is converted into the each of the plurality of fuzzy inputs by corresponding input membership functions; and
the fuzzy output is converted into the output of the fuzzy logic by an output membership function.

9. The method according to claim 7 or 8, wherein
the plurality of fuzzy inputs is mapped into the fuzzy output by a fuzzy inference; wherein
the fuzzy inference maps the fuzzy inputs into the fuzzy output by modelling relationships between the fuzzy inputs and the fuzzy output.

10. The method according to any one of claims 3 to 9, wherein
the state of charge and the derating factor are positively correlated; and/or
the voltage difference between the measured voltage and the estimated voltage and the derating factor are negatively correlated.

11. The method according to claim 9, wherein
the input membership functions, the output membership function and the fuzzy inference are such that the fuzzy logic achieves the following relations:
the state of charge and the derating factor are positively correlated; and/or
the voltage difference between the measured voltage and the estimated voltage and the derating factor are negatively correlated.

12. The method according to any one of claims 1 to 11, wherein
the derated power limit is a maximum discharge power of a battery when the battery is discharging; or
the derated power limit is a maximum charge power of a battery when the battery is charging.

13. A device for determining a derated power limit of a battery, the device configured to:
estimate a power limit of the battery;
acquire a plurality of inputs from the battery;
determine a derating factor for the power limit by applying a fuzzy logic to the plurality of inputs; and
determine the derated power limit by multiplying the derating factor to the power limit.

14. A vehicle comprising the device according to claim 13.
